# EUROPEAN PATENT APPLICATION

(11) **EP 2 629 338 A2**
(43) Date of publication of application: **21.08.2013**
(21) Application number: 13382011.8
(22) Date of filing: 16.01.2013
(51) Int. Cl.: H01L 31/042, H01L 31/045

(54) **Autonomous and portable solar energy equipment**

(30) Priority: 20.02.2012 ES 201230174 U
(71) Applicant: Hijazi Guiniat, Amer, 28030 Madrid (ES)
(72) Inventor: Hijazi Guiniat, Amer, 28030 Madrid (ES)
(74) Representative: Díaz de Bustamante y Terminel, Isidro

(57) **Abstract**

AUTONOMOUS AND PORTABLE SOLAR ENERGY EQUIPMENT which works as a autonomous system in places without power grid; as a complementary system in grid-connected installations; and as an emergency system in case of power grid failure, consisting of a portable briefcase (2), housing: six photovoltaic modules (3); Bypass contactor (4), for differentiating the input to a load regulator (5) or a grid inverter (6); converter (8); accumulation batteries(9); and battery loader (10); as well as control and connection elements: switches (20) sockets (21) and wiring; and safety ones, for AC - 230V: meter, power and consumption control, protection from overload and short-circuit in consumption, protection from overload and short-circuit in load line; and for DC - 12 V: safety fuses.

## Description

### OBJECT OF THE INVENTION

The invention, as exposed on the wording of the present specification, relates to an autonomous and portable solar energy equipment, imparting to the function it is intended to, several advantages and innovative characteristics, which will be described in detail below and which mean a remarkable innovation.

More particularly, the object of the invention focuses on a solar capturing equipment designed for supplying energy to the users at any time, situation and place, becoming an energy supply system which, having the exploitation of solar energy as main source of work, presents, essentially, a triple functionality: as a autonomous system for isolated places without power grid; as a self-consumption and electricity bill reduction system in grid-connected installations; and as an emergency system in case of power grid failure or UPS (Uninterruptable Power Supply).

### APPLICATION FIELD OF THE INVENTION

The application field of the present invention is framed within the technical sector of renewable energies, more specifically, in the field of photovoltaic solar energy.

### BACKGROUND OF THE INVENTION

Solar energy is struggling to make a space for itself in homes, but its high cost, the installation and orientation of the panels, the need of an electrical wiring parallel to the existing one, and the adaptation of power-efficient devices and luminaries, involve a change of mind in the consumer.

The exploitation of a cheap and accessible energy like the one provided by the sun, has driven a greet advance and development in systems capable of capturing this energy, and therefore systems offering mobility and autonomy are proliferating.

However, and referring to the state of the art, it must be pointed that, although it is true that there are autonomous solar capturing solutions, at least by the applicant, it is unknown the existence of any other equipment or invention of similar application presenting technical, structural and constitutive characteristics similar to the ones presented by the autonomous and portable solar energy equipment herein recommended and as it is claimed.

### EXPLANATION OF THE INVENTION

Thus, the autonomous and portable solar energy equipment proposed by the invention is configured as a remarkable novelty within its field of application, as it is designed for providing energy to the users at any day time, situation and place, becoming a solar energy supply system whose ease of operation and understanding, its adaptability and ease of transportation, make it a useful household product, and essential for the countryside, in isolated dwellings, campsites, motor caravans, boats, equipment for isolated works, NGOs in humanitarian assistance camps, etc. And at the same time adaptable to the dwelling's inner grid, allowing a household use, in the usual residence.

Specifically, what the invention proposes is, as it has been already indicated previously, an autonomous and portable solar energy equipment which, packed in a small-sized suitcase and weighting barely 30 kilograms, incorporates a set of photovoltaic modules connected to a BY-PASS so that: manually, the user can select the desired work option, depending on the situation at any time; and, automatically, detect a connection to the grid or problems thereof for working in isolated mode or connected to the grid.

So, the equipment of the invention is a unit combining mobility, with the energetic use therefore it is based in the existence of an accumulation system (batteries) which grants autonomy out of the connection to any point of the power grid.

As a generation support it incorporates the mentioned adaptable photovoltaic modules system for loading the system. Essentially, said module is the portion of the equipment responsible for the energy generation.

The system can, based on this photovoltaic generation, define its destination as a function of its use.

Thus, if it is operating autonomously, the direction of the generation will be addressed to the loading of batteries, but one can choose to complete an energy saving system directly connected to the consumption inner power grid itself.

If it is connected to a power grid, the equipment utilizes a load electronics of 230V AC for being capable of maintain the system operational.

Moreover, the operation possibilities of the equipment of the invention give it the possibility of being used also as a UPS system, typical safety system for possible power outages in computers.

This emergency service allows it for being connected to internal grid in the absence of the power grid.

The recommended equipment is characterized then, by combining mobility with energy autonomy, in a compact unit with the ability to provide various possibilities of use. In conclusion innovating and developing a new integrated system which perfects and improves other photovoltaic solar energy capturing systems, providing, in a single system autonomy, energy saving and UPS protection.

In order to achieve said performance, the equipment has the following more remarkable characteristics:
- Easy mobility: all the components are integrated in a compact manner within a suitcase protected from blows and with a handle resistant to the weight of the ensemble so as to facilitate the transportation thereof and to be usable in any place with or without connection to a commercial power grid.
- Easy assembly and disassembly of the different photovoltaic modules so as to locate them with the desired slope and orientation, so as to avoid shadows of possible obstacles and exploit better solar radiation, being able to modify said location as the sun position changes.
- Use at any time of day or night thanks to the batteries with which the user will have energy also in the moments in which he/she is not receiving solar radiation and is disconnected from the power grid.
- Use in any situation, since, being an independent and portable system, the user will can always count on it for emergency situations or foreseen situations of lack of energy supply in order to solve specific electric problems.
- Not dependent on fuels. By exploiting the free and clean energy from the sun, it is avoided the dependency on fuels, saving the user expenses and problems caused by consumption and storing thereof, as well as in environmental pollution both due to gas emissions and to noises.

Being desirable, in newly built houses, the location of spaces for the installation of photovoltaic modules, the positioning of converters and accumulators of this energy, the present invention goes a step farther, through the reduction of the equipment, to the extent of making it transportable by a single person.

In the light of the aforementioned, it is stated that the described autonomous and portable solar energy equipment represents an innovation with characteristics unknown so far to this end, reasons which in combination with its practical utility, provide it with enough basis to obtain the exclusivity privilege which is applied for.

### DESCRIPTION OF THE DRAWINGS

In order to complement the description being fulfilled of the invention and with the aim of helping to a better understanding of the characteristics characterizing it, the present specification is accompanied, as an integral part thereof, by a set of plans, in which by way of illustration and not of limitation, is represented the following:
Figure number 1. Shows a perspective view of an example embodiment of the autonomous and portable solar energy equipment object of the invention, being appreciated on it its general configuration with the briefcase in which the elements it comprises are incorporated and showing some of the photovoltaic modules arranged around it.
Figure number 2. Shows a perspective view of the interior of the briefcase housing the elements of the equipment of the invention, being appreciated on it, besides the fastenings of the lid for the photovoltaic modules, the protective plate covering the rest of elements housed in the base.
Figure number 3. Shows, in a block diagram, a schematic representation of the main elements of the autonomous equipment of the invention, wherein besides said elements are represented a set of arrows interrelating them, serving as a diagram so as to illustrate its operation.

### PREFERRED EMBODIMENT OF THE INVENTION

In light of the mentioned figures, and according to the numbering taken, it can be seen on them an example of preferred embodiment of the invention, which comprises the parts and elements indicated and described in detail below.

Thus, as can be seen in said figures, the equipment (1) in question comprises, housed within a portable briefcase (2) the following essential elements:
- Several units of photovoltaic modules (3), preferably, six units of (16*6) = 96wp, with the following characteristics:
   Power 16 Wp
   Open circuit voltage 3.5 Vco
   Short-circuit current 0.7 Acc
   Voltage in maximum power point 3V Vmpp
   Current of maximum power point 0.6 Vmpp
- As switches, a contactor of 25A Bypass (4), in order to differentiate solar input towards a regulator (5) or an inverter (6)
- A regulation equipment, formed by the previously mentioned regulator (5), for the control and measurement of the solar loading. It works at 12/48V, and the voltage control is through leds. Thus, the solar loading is optimized, providing the maximum energy generation, through the tracking of the maximum power point (mpp), said loading regulator (5) having a display (7), wherein is displayed:
   - Battery voltage
   - Battery loading intensity
   - total Kwh day generated
   - Log of maximum generation
   - Log of loading end
- A converter (8) preferably CON 250 with the following technical characteristics:
   - Outoput voltage: 115 or 230 V AC
   - Stable frequency in 50 or 60 Hz
   - Input voltage 12 V DC
   - Galvanic separation
   - Protection from short-circuits and polarity inversion
- Gel batteries (9) of 6A
- A grid inverter (6), preferably Sineo 250 with the following characteristics:
   - Maximum input current 18A
   - Rated power output 250w AC
   - Voltage 230Vac / 50Hz
- A battery loader (10) of 1.5A

Regarding all the preceding, the performance of the example of preferred embodiment of the equipment will be:
- Photovoltaic solar system of 100 Wp
- Autonomy of 300 Wp at unloading of 100 H
- Ability for providing up to 900 Wh/day of consumption in AC.

On its part, the briefcase (2) will have standardized dimensions 435 x 350 x 200m, suitable for housing conveniently the mentioned photovoltaic modules (3) and the rest of elements of the equipment, having also a handling handle of sufficient resistance for bearing it, since the ensemble has a weight of about 30 kg.

Moreover, the briefcase (2), which externally is made of rigid and resistant material so as to serve as a protection from blows, has internally fastening means (15) for incorporating the photovoltaic modules in the lid (2a) thereof, such that they are fastened to the lid, and a separating plate (16), preferably of transparent methacrylate, which covers and protects the other electrical elements, batteries (9) etc., which are to be housed in the base (2b) of said briefcase.

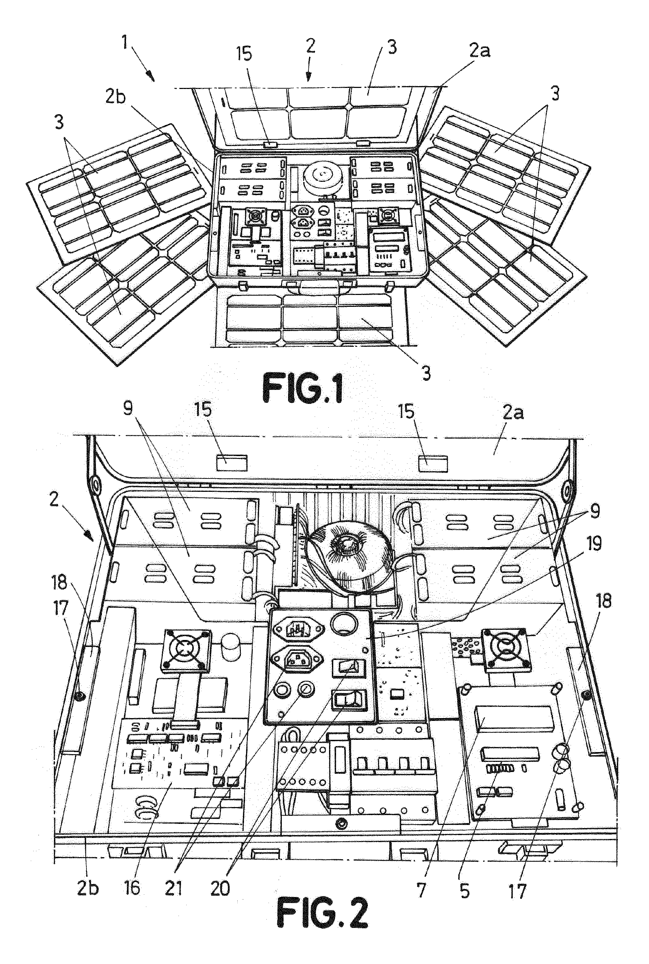

Said plate (16), preferably, is fastened to the edges of the base (2b) of the briefcase through screws (17) threaded in respective holders (18) intended to this end, and presents, at least, an opening (19) which grants free access to the switches (20) and connection sockets (21) of the equipment, covering the other elements, such that these are protected from dust and dirt, as can be seen in figure 2.

It is advisable to remark, also, that, although not represented, the equipment contemplates that the photovoltaic modules (3) have a back holder adjustable which, in the moment of using the equipment, allows for positioning them with different slope for adjusting them in the most convenient manner, according to the sun position, logically close to the briefcase depending on the reach of the connection wires.

Finally it is advisable to point that, the equipment is designed for meeting the EEC regulations, having the corresponding safety elements:

For AC -230V (consumption 230v AC)
- Meter. Power and consumption control.
- Protection from overload and short-circuit in consumption.
- Protection from overload and short-circuit in load line.

And for DC -12 V (consumption in 12v DC)
- Safety fuses.

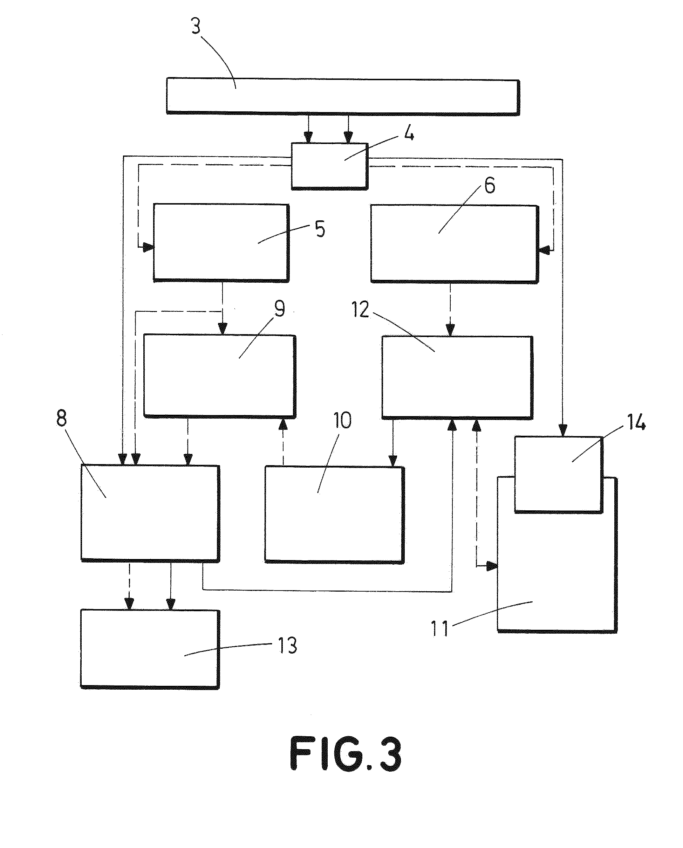

Below, the three operative modes of the equipment are described, represented in the diagram of figure 3:
- As an autonomous system for isolated places without connection to a power grid.

In this working mode, the equipment can supply energy at 12V of direct current (DC) or at 220V 50Hz (or 115V 60Hz on request of the user) of alternating current (AC).

The basic operation in this form of energy supply is the following:
- The solar energy captured by the photovoltaic modules (3) the equipment is fitted with, is transformed in DC at 12V.
- This energy 12V DC is controlled by the regulator (5), so as to make full use of the power of the modules with the MPPT technology (maximum power point tracker), with which one gets a 35% more production.

The output energy at 12V DC of said regulator (5), will be used:

To feed the consumptions connected at that moment; according to the type of current needed for the consumption:
- Directly in the 12VDC socket, to which a universal connector/plug of vehicle lighter is incorporated.
- In the 220V 50Hz in AC socket, for what the energy at 12VDC is transformed by the converter (8) to 220V 50Hz (or 115V 60Hz on request of the user) of alternating current (AC).

Or to load the batteries (9), for storing the excess energy, not needed by the consumptions in that moment, and thus being available in moments of sun absence.
- As a self-consumption and electricity bill reduction system in places with connection to a power grid, represented said grid connection, in the block diagram of figure 3, with the reference (11).

In this working mode, the equipment, in places where it can be connected to the power grid (11), becomes a complementary energy source in AC, for supplying energy to the consumptions (12) connected to said grid and, in case that said consumptions exceed the solar output, the energy demand of the grid will be completed (11).

In this manner the user will be able to reduce the electricity bill, as the equipment provides part or all of the energy being consumed in those moments.

The basic operation in this form of energy supply is the following:
- The solar energy captured by the photovoltaic modules (3) is transformed in DC at 12V.
- This energy 12VDC is transformed by the inverter (6) in 220V 50Hz (or 115V 60Hz on request of the user) of alternating current (AC).
- The output energy in AC of the inverter (6), will be directly injected in the nearest socket of the setting's inner grid.
- In the case that the batteries (9) are not completely loaded, in this working mode, the energy of the grid will be exploited (both the injected by the equipment and the one coming from the power supplier) so as to complete said load, through the loader (10) incorporated in the equipment to this end, and having them available in moments of grid absence.

And as an emergency system by failure of the la power grid.

In this working mode, the equipment will work as a uninterruptable power supply, such that the user having connected some equipment, apparatus or luminaries (pointed in the diagram of figure 3 with the reference (13)) to the equipment of the invention and this one, in turn, to the power grid (11), will be assured that, in case of failure in the power grid (represented in the operating diagram as the block referenced as (14)), will still have the energy needed for developing the activity he/she was executing in the moment previous to the power outage from the grid. Therefore the equipment will operate as a UPS.

Having sufficiently described the nature of the present invention, as well as a way of putting it into practice, it is not considered necessary to make a more extensive explanation in order that any expert in this area will understand its scope and the advantages that can be derived from it, making known that, within reason it could be put into practice in other embodiments differing in detail from that indicated by way of example, and which will obtain the same degree of protection, provided that they do not alter, change, or modify its fundamental principle.

## Claims

1. AUTONOMOUS AND PORTABLE SOLAR ENERGY EQUIPMENT which, being of the type which provides power supply from photovoltaic modules (3), is applicable for working as a autonomous system in places without power grid; as a complementary system in grid-connected installations; and as an emergency system in case of power grid failure, being **characterized in that**, housed in a portable briefcase (2), it comprises:
- several units of photovoltaic modules (3),
- a Bypass contactor-type switch (4), so as to differentiate solar input towards a regulator (5) or an inverter (6),
- a solar load regulator (5),
- a converter (8),
- accumulation batteries (9),
- a grid inverter (6),
- a battery loader (10),
as well as the rest of elements allowing its operation for converting the solar energy captured by said photovoltaic modules (3) in electric power, consisting both of control and connection elements, such as switches (20) sockets (21) and wiring, and of safety ones, for AC -230V, as a meter, power and consumption control, protection from overload and short-circuit in consumption, protection from overload and short-circuit in load line; and for DC -12 V, as safety fuses.

2. AUTONOMOUS AND PORTABLE SOLAR ENERGY EQUIPMENT, according to claim 1, **characterized in that** inside the briefcase (2) it incorporates six photovoltaic modules (3) of 16 Wp power each; **in that** the Bypass contactor (4) is of 25A; **in that** the regulator (5) acts between 12/48V, and the voltage control is through leds, makes maximum power point (mpp) tracking, and has a display (7) where different parameters are displayed; **in that** the converter (8) is 250, with output voltage: 115 or 230 V AC, stable frequency in 50 or 60 Hz, input voltage 12 V DC, galvanic separation and protection from short-circuits and polarity inversion; **in that** the batteries (9) are gel batteries of 6A; **in that** the grid inverter (6) is Sineo 250 with maximum input current 18A, rated power output 250w Ca and voltage 230Vac / 50Hz; **in that** the battery loader (10) is of 1.5A

3. AUTONOMOUS AND PORTABLE SOLAR ENERGY EQUIPMENT, according to claim 1 or 2, **characterized in that** the briefcase (2) has standardized dimensions 435 x 350 x 200m, and the ensemble weights about 30 kg.

4. AUTONOMOUS AND PORTABLE SOLAR ENERGY EQUIPMENT, according to any one of claims 1-3, **characterized in that** the briefcase (2), externally is made of rigid and resistant material, and internally has fastening means (15) so as to incorporate the photovoltaic modules (3) in the lid (2a) thereof, such that they are fastened to the lid, and with a separating plate (16), which covers and protects the other electrical elements, batteries (9) etc., which are housed in the base (2b) of said briefcase.

5. AUTONOMOUS AND PORTABLE SOLAR ENERGY EQUIPMENT, according to claim 4, **characterized in that** the separating plate (16) is transparent, is fastened to the edges of the base (2b) of the briefcase in respective holders (18) intended to this end, and presents, at least, an opening (19) which grants free access to the switches (20) and connection sockets (21) of the equipment, covering the other elements.

6. AUTONOMOUS AND PORTABLE SOLAR ENERGY EQUIPMENT, according to any one of claims 1-5, **characterized in that** the photovoltaic modules (3) have back holder adjustable which allows for positioning them with different slope for adjusting them in the most convenient manner, according to the sun position.
